(19)

**Europäisches Patentamt**
**European Patent Office**
**Office européen des brevets**

(11) **EP 2 136 413 A2**

(12) **EUROPEAN PATENT APPLICATION**

(43) Date of publication:
**23.12.2009 Bulletin 2009/52**

(51) Int Cl.:
**H01L 31/075** (2006.01)  **H01L 27/142** (2006.01)

(21) Application number: **09006893.3**

(22) Date of filing: **22.05.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**

(30) Priority: **19.06.2008 KR 20080057797**

(71) Applicant: **Samsung Electronics Co., Ltd.**
**Yeongtong-gu**
**Suwon-city, Gyeonggi-do 442-742 (KR)**

(72) Inventors:
• **Lee, Czang-Ho**
**Suwon-si**
**Gyeonggi-do (KR)**
• **Shin, Myung-Hun**
**Suwon-si**
**Gyeonggi-do (KR)**
• **Jung, Seung-Jae**
**Seoul (KR)**

• **Seo, Joon-Young**
**Seoul (KR)**
• **Oh, Min-Seok**
**Yongin-si**
**Gyeonggi-do (KR)**
• **Lee, Byoung-Kyu**
**Cheonan-si**
**Chungcheongnam-do (KR)**
• **Kang, Ku-Hyun**
**Suwon-si**
**Gyeonggi-do (KR)**
• **Lim, Mi-Hwa**
**Chungcheongnam-do (KR)**

(74) Representative: **Weitzel, Wolfgang**
**Patentanwalt**
**Friedenstrasse 10**
**89522 Heidenheim (DE)**

(54) **Photovoltaic device**

(57)     Photovoltaic devices and methods of manufacturing the same are provided. In one example, a photovoltaic device includes: a substrate; a transparent conductive layer deposited on the substrate; a semiconductor layer provided with a P layer, an I layer, and a N layer sequentially deposited on the transparent conductive layer; and a rear electrode deposited on the N layer of the semiconductor layer, wherein the P layer is a P-type oxide semiconductor.

## FIG. 1

EP 2 136 413 A2

## Description

## CROSS-REFERENCE TO RELATED APPLICATION

This application claims priority to and the benefit of Korean Patent Application No. 10-2008-0057797 filed in the Korean Intellectual Property Office on June 19, 2008, the entire contents of which are incorporated herein by reference.

## BACKGROUND OF THE INVENTION

### (a) Field of the Invention

The present invention relates to photovoltaic devices using an oxide semiconductor of a P type.

### (b) Description of the Related Art

A photovoltaic device converts light energy into electric energy. There are various kinds of photovoltaic devices according to the type of metal used, and one among them is a solar cell. A solar cell that converts the solar light energy into electric energy generates electricity by using two kinds of semiconductors that are referred to as a P-type semiconductor and a N-type semiconductor.

The solar cells are largely categorized as a crystalline silicon solar cell that is used in most commercial products, a thin film solar cell that can use an inexpensive substrate, and a hybrid solar cell of the crystalline silicon solar cell and the thin film solar cell.

The crystalline silicon solar cell uses a silicon slice in which a silicon lump is thinly cut for a substrate, and is categorized as a monocrystalline solar cell and a polycrystalline solar cell according to a method of manufacturing the silicon. The crystalline silicon solar cell, for example the monocrystalline solar cell, has a P-N junction structure consisting of a N-type semiconductor in which a pentavalent element such as phosphorus, arsenic, or antimony is added to silicon, and a P-type semiconductor that is formed by doping a trivalent element such as boron or potassium into silicon, and structures thereof are substantially identical to that of a diode.

The thin film solar cell is formed using a method of coating a film on a thin glass or plastic substrate, and since the spread distance of the carrier is generally short under characteristics of the thin film solar cell compared with the crystalline silicon solar cell, collection efficiency of electron-hole pairs generated by the solar light is very low when it is only made of the P-N junction structure such that a PIN structure in which a light absorption layer of an intrinsic semiconductor material having high light absorption efficiency is inserted between the P-type and the N-type semiconductors is applied. Generally, in the structure of the thin film solar cell, a front transparent conductive layer, a PIN layer, and a rear reflecting electrode layer are deposited in sequence on a substrate. In this structure, the light absorption layer is depleted by the P and N layers having the high doping concentration of the upper and lower sides, and then an electric field is generated such that the carriers generated by the solar light in the light absorption layer generate a current by the inner electric field drift in which the electrons are transferred to the N layer and the holes are transferred to the P layer.

In reality, various elements influence the light efficiency in the manufacturing process of the solar cell such that the design of the cell structure and the characteristics and the thickness of the cell-forming layers may be carefully selected, and particularly the P layer and the interface between the P layer and the I layer largely influence the characteristics of the solar cell. This is because the solar light is initially incident to the P layer through the front transparent conductive layer and must be provided into the I layer as the light absorption layer while minimizing the loss of light absorption in the P layer. Also, the carriers generated by the solar light in the light absorption layer must have a low recombination probability in the interface between the P layer and the I layer where the recombination centers are largely distributed. In conclusion, if the loss of the light absorption of the P layer and the recombination probability in the interface between the P layer and the I layer is increased, the light collection ratio is deteriorated in the short wavelength region thereby reducing light efficiency.

The above information disclosed in this Background section is only for enhancement of understanding of the background of the invention and therefore it may contain information that does not form the prior art that is already known in this country to a person of ordinary skill in the art.

## SUMMARY OF THE INVENTION

Accordingly, the present invention provides a photovoltaic device having excellent band gap and electric conductivity characteristics to maximize light efficiency.

A photovoltaic device according to an embodiment of the present invention includes: a substrate; a transparent conductive layer deposited on the substrate; a semiconductor layer provided with a P layer, an I layer, and a N layer sequentially deposited on the transparent conductive layer; and a rear electrode deposited on the N layer of the semiconductor layer, wherein the P layer is a P-type oxide semiconductor.

The difference of the band gap between the P layer and the I layer may be in the range of 1.5eV to 2.5eV.

A buffer layer disposed between the P layer and the I layer for buffering the difference of the band gap between the P layer and the I layer may be further included.

The buffer layer may be made of one selected from a group of amorphous carbon (a-C), amorphous silicon carbide (a-SiC), and amorphous silicon oxide (a-SiO).

The P-type oxide semiconductor may include at least one of Ga, In, Zn, Sn, Cu, Al, Sr, La, and Hf.

The P-type oxide semiconductor may be made of at least one of $CuAlO_2$, $CuGaO_2$, $SrCu_2O_2$, and (LaO)CuS.

The band gap of the P-type oxide semiconductor may be in the range of 3.0eV to 3.5eV.

The thickness of the P-type oxide semiconductor may be in the range of 200Å to 1000Å.

The I layer may be made of at least one selected from a group of amorphous silicon (a-Si), microcrystalline silicon ($\mu$c-Si), monocrystalline silicon (Si), cardmium telluride (CdTe), copper·indium·gallium·selenium (CIGS), and gallium arsenide (GaAs).

The thickness of the I layer may be in the range of 3000Å to 6000Å.

The thickness of the transparent conductive layer may be in the range of 7000Å to 10,000Å.

The band gap of the I layer may be in the range of 1.0eV to 2.0eV.

The semiconductor layer may be a multi-layered structure in which the P layer, the I layer, and the N layer are sequentially deposited a plurality of times.

The P layer and the I layer may have different band gaps.

A photovoltaic device according to another embodiment of the present invention includes: a substrate; a transparent conductive layer deposited on the substrate; a semiconductor layer provided with a P layer, an I layer, and a N layer sequentially deposited on the transparent conductive layer; and a rear electrode deposited on the P layer of the semiconductor layer, wherein the N layer is a N-type oxide semiconductor.

The difference of the band gap between the N layer and the I layer may be in the range of 1.5eV to 2.5eV.

The N-type oxide semiconductor may include at least one of Ga, In, Zn, Sn, Cu, Al, Sr, La, and Hf.

The N-type oxide semiconductor may be made of at least one of $AgInO_2$, AlO, and ZnO doped with an impurity at a low concentration.

A buffer layer disposed between the N layer and the I layer for buffering the difference of the band gap between the N layer and the I layer may be further included.

The I layer may be made of at least one selected from a group of amorphous silicon (a-Si), microcrystalline silicon ($\mu$c-Si), monocrystalline silicon (Si), cadmium telluride (CdTe), copper·indium·gallium·selenium (CIGS), and gallium arsenide (GaAs).

A reflecting electrode disposed between the substrate and the transparent conductive layer may be further included.

A connection electrode formed on the rear electrode may be further included.

A manufacturing method of a photovoltaic device according to another embodiment of the present invention includes: depositing a transparent conductive layer on a substrate; patterning the transparent conductive layer; forming a semiconductor layer including a P layer, an I layer, and a N layer sequentially deposited on the patterned transparent conductive layer; patterning the semiconductor layer; forming a rear electrode layer on the patterned semiconductor layer; and patterning the rear electrode layer and the semiconductor layer, wherein the P layer is made of a P-type oxide semiconductor.

A manufacturing method of a photovoltaic device according to another embodiment of the present invention includes: depositing a transparent conductive layer on a substrate; forming a P layer on the transparent conductive layer; patterning the transparent conductive layer and the P layer; sequentially depositing an I layer and a N layer on the P layer; patterning a semiconductor layer including the P layer, the I layer, and the N layer; forming a rear electrode layer on the patterned semiconductor layer; and patterning the rear electrode layer and the semiconductor layer, wherein the P layer is made of a P-type oxide semiconductor.

Texture-treating the surface of the transparent conductive layer to form a texture layer after depositing the transparent conductive layer may be further included.

The transparent conductive layer, the semiconductor layer, and the rear electrode layer may be patterned by laser scribing.

The transparent conductive layer, the semiconductor layer, and the rear electrode layer may be patterned by laser scribing having a wavelength of 1.06$\mu$m or 0.53$\mu$m.

According to the present invention, an oxide semiconductor having wide band gap energy is applied such that a short circuit current (Isc), an open circuit voltage (Voc), and a fill factor (FF) that are variables of the light efficiency of the solar cell are improved, thereby maximizing the light efficiency of the solar cell and improving the reliability of the solar cell characteristics.

## BRIEF DESCRIPTION OF THE DRAWINGS

FIG. 1 is a cross-sectional view of a solar cell according to an embodiment of the present invention.
FIG. 2A to FIG. 2C are graphs respectively showing light transmittance according to wavelength for a transparent conductive layer, a P-type amorphous silicon carbide and a P-type oxide semiconductor.
FIG. 3A and FIG. 3B are graphs of a case in which amorphous silicon carbide is used as a P layer of a solar cell and a case in which an oxide semiconductor is used as a P layer as in an embodiment of the present invention.
FIG. 4 is a graph showing expected light efficiency according to energy band gap of a light absorption layer for explaining a solar cell according to an embodiment of the present invention.
FIG. 5A to FIG. 5F are cross-sectional views sequentially showing the manufacturing process in a manufacturing method of a solar cell according to an embodiment of the present invention.

FIG. 6 is a cross-sectional view of a solar cell of a substrate type according to an embodiment of the present invention.

## DETAILED DESCRIPTION OF THE EMBODIMENTS

An embodiment of the present invention will hereinafter be described in detail with reference to the accompanying drawings. As those skilled in the art would realize, the described embodiments may be modified in various different ways, all without departing from the spirit or scope of the present invention. The present embodiments provide fulldisclosure of the present invention and information of the scope of the present invention to those skilled in the art. In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it can be directly on the other element or intervening elements may also be present.

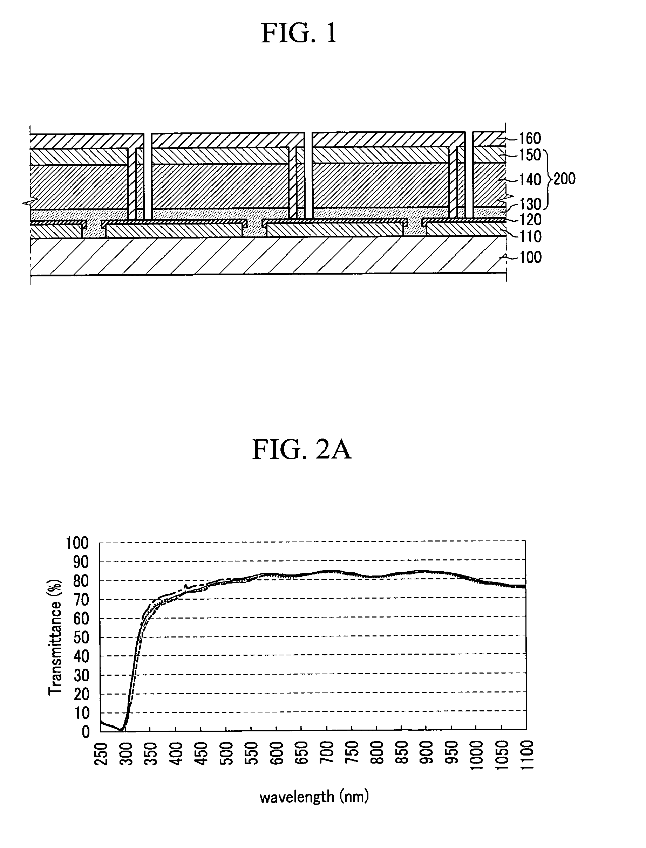

FIG. 1 is a cross-sectional view of a solar cell according to an embodiment of the present invention.

Referring to FIG. 1, a solar cell according to an embodiment of the present invention includes a transparent conductive layer 110 deposited on a substrate 100. The transparent conductive layer 110 may be made of $SnO_2$, ZnO:Al, or ZnO:B in one example. A texture layer 120 formed by a texture treatment is formed on the surface of the transparent conductive layer 110. The transparent conductive layer 110 may be patterned.

The texture layer 120 may be made with a pyramid structure of a size within $10\mu m$ by etching the surface of the transparent conductive layer 110 for increasing the absorption efficacy of light to the interior of the solar cell.

A thin film silicon solar cell has a short diffusion distance of electron-hole pairs compared with a crystalline silicon PN junction solar cell that is operated by electron-hole pairs generated by solar light, such that an intrinsic semiconductor layer for simultaneously generating a light absorption layer and an inner electric field may be inserted between a P layer and a N layer. The intrinsic semiconductor may be an I layer 140 in an embodiment of the present invention.

The solar cell according to an embodiment of the present invention includes the P layer 130 formed on the texture layer 120. The I layer 140 and the N layer 150 are sequentially formed on the P layer 130. The I layer 140 and the N layer 150 may be deposited by plasma chemical vapor deposition (PECVD) in one example. The P layer 130, the I layer 140, and the N layer 150 may be patterned. A rear electrode layer 160 is deposited on the N layer 150. The rear electrode layer 160 may be patterned.

Electron-hole pairs generated by solar light in the light absorption layer generate a current by drift of an inner electric field in which the electrons are transfered to the N layer 150 and the holes are transfered to the P layer 130.

The solar light is incident to the P layer 130 by passing through the transparent conductive layer 110 such that loss of light absorption must be minimized in the P layer 130 to increase a light collection ratio in the I layer 140 as the light absorption layer.

To increase the light efficiency, the P layer 130 may be made of P-type amorphous silicon carbide (a-SiC) doped with $B_2H_6+CH_4$ having a relatively larger band gap than P-type amorphous silicon (Eg=1.7-1.8eV) doped with $B_2H_6$. However, if the band gap is increased, the electric conductivity is decreased. Accordingly, the conditions of the P-type amorphous silicon carbide are determined through a compromise between the band gap and the electric conductivity.

Generally, the conditions of the P-type amorphous silicon carbide applied to the solar cell include a thickness of 100-200Å, band gap of 1.9-2.0eV, and electric conductivity of $10^{-7}$(S/cm). However these are low values to obtain high efficiency by increasing the light collection ratio of the short wavelength region. To compensate, a P-type microcrystalline silicon ($\mu$c-Si) having a large Eg and electric conductivity may be applied, however there are problems such as a low deposition speed, a narrow processing window, and surface damage to the $SnO_2$ front transparent conductive layer by hydrogen plasma during deposition. Also, $CH_4$ graded amorphous silicon carbide may be applied to decrease the recombination of the electron-hole pairs in the interface between the P layer and the I layer, however the height of the barrier is low such that it is difficult to completely block electron backflow.

To sum up, to manufacture the solar cell having high efficiency, the semiconductor layer where the solar light is incident must have a relatively large band gap and excellent optical transmittance in all wavelength regions of the incident solar light, and a good ohmic contact characteristic. Also, to improve the open circuit voltage (Voc) it is preferable to have low thermal conductivity energy (Ea).

To solve the problems, the P layer 130 according to an embodiment of the present invention may be formed of a P-type oxide semiconductor. When compared with amorphous silicon carbide (a-SiC), the oxide semiconductor has the band gap of more than 1eV, high optical transmittance in all wavelength regions, high electric conductivity, and low thermal electric conductivity energy (Ea) such that it is preferable to use the oxide semiconductor as the P layer.

The P-type oxide semiconductor may include at least one selected from Ga, In, Zn, Sn, Cu, Al, Sr, La, and Hf. Here, the P-type oxide semiconductor may be made of at least one selected from $CuAlO_2$, $CuGaO_2$,

SrCu$_2$O$_2$, and (LaO)CuS.

The P layer 130 and the I layer 140 may have different band gaps from each other. The band gap difference between the P layer 130 and the I layer 140 may be in the range of 1.5eV to 2.5eV in one example.

The band gap of the P-type oxide semiconductor may be in the range of 3.0eV to 3.5eV in one example.

The thickness of the P-type oxide semiconductor may be in the range of 200Å to 1000Å in one example.

The I layer 140 as the light absorption layer may be made of one selected from the group of amorphous silicon (a-Si), microcrystalline silicon ($\mu$c-Si), monocrystalline silicon (Si), cardmium telluride (CdTe), copper·indium·gallium·selenium (CIGS), and gallium arsenide (GaAs).

The band gap of the I layer 140 may be in the range of 1.0eV to 2.0eV in one example. The thickness of the I layer 140 may be in the range of 3000Å to 6000Å in one example.

A buffer layer (not shown) may be disposed between the P layer 130 and the I layer 140. The buffer layer functions to buffer the difference of the band gap Eg between the P layer 130 and the I layer 140.

In detail, the P-type oxide semiconductor has a high band gap such that a steep decrease of the band gap is generated between the P layer and the I layer when the I layer includes a heterojunction structure thereby generating defects, and the buffer layer may prevent the defects.

The buffer layer may be made of one selected from the group of amorphous carbon (a-C), amorphous silicon carbide (a-SiC), and amorphous silicon oxide (a-SiO).

The semiconductor layer 200 is comprised of the P layer 130, the I layer 140, and the N layer 150. The semiconductor layer 200 may be a multi-layered structure in which the P layer 130, the I layer 140, and the N layer 150 are sequentially deposited a plurality of times. That is, the multi-layered structure may be a tandem structure in which the sequence of PIN/PIN is deposited, a triple-junction structure in which the sequence of PIN/PIN/PIN is deposited, or a multi-junction structure. When the semiconductor layer 200 has the multi-layered structure, the light absorption region is widened.

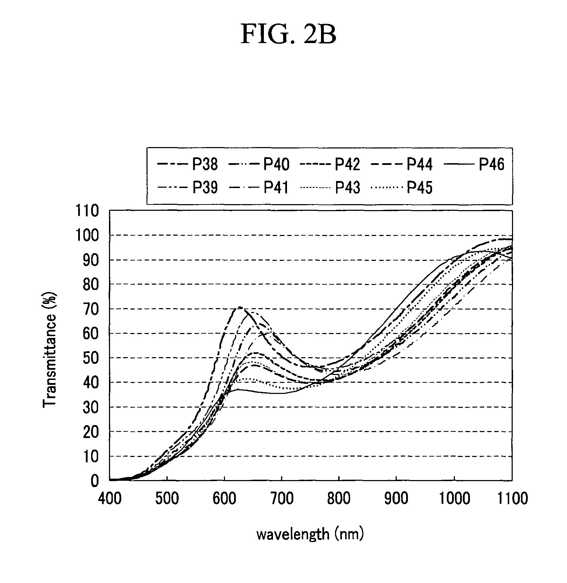

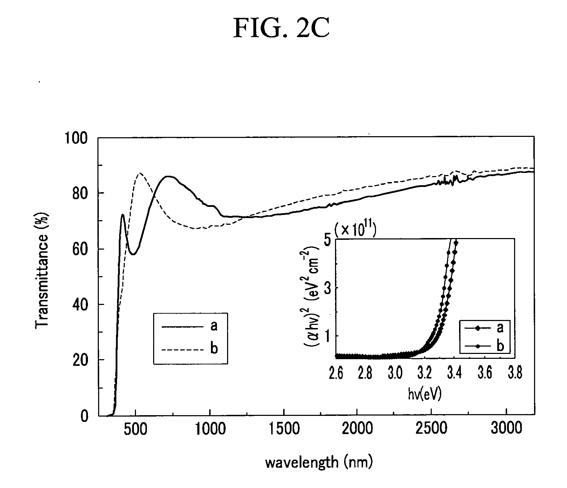

Referring now to FIG. 2, the effects provided when the P-type oxide semiconductor is used as the P layer will be compared with the case in which the amorphous silicon carbide is used as the P layer.

FIG. 2A is a graph showing light transmittance of a transparent conductive layer made of SnO$_2$, FIG. 2B is a graph showing light transmittance of P-type amorphous silicon carbide, and FIG. 2C is a graph showing light transmittance of a P-type oxide semiconductor.

Referring to FIG. 2A, the transparent conductive layer 110 that may be used as a front electrode has high light transmittance at most wavelengths.

Referring to FIG. 2B, P38, P39,..., P46 indicate each of experimental samples, and they show similar distributions. Referring to FIG. 2B, the light transmittance is low in the short wavelength region.

In FIG. 2C, the light transmittance of the case in which the P-type oxide semiconductor is used as the P layer is similar to the light transmittance of the transparent conductive layer 110 shown in FIG. 2A. That is, the solar light of the region of near infrared rays is little absorbed in visible light and may be passed to the I layer as the light absorption layer. The P-type oxide semiconductor may use SrCu$_2$O$_2$ in one example.

In the solar cell according to an embodiment of the present invention, the effects of the case in which the P-type oxide semiconductor is used as the P layer will be described in detail.

When the P-type oxide semiconductor having a large band gap is used as the P layer, it has high light transmittance in the region of the visible rays and the near infrared rays such that the solar light may be transmitted to the I layer 140 as the light absorption layer without a loss of light absorption. Resultantly, the electron-hole pairs for the light generation are increased such that the light current is increased, thereby improving the Isc value. Furthermore, the thickness of the I layer 140 may be reduced because of the sufficient light current.

The P-type oxide semiconductor exhibits high electric conductivity such that the contact resistance between the transparent conductive layer 110, the P layer 130, and the I layer 140 may be reduced, thereby improving the fill factor (FF) of the solar cell.

Also, the thermal electric conductivity energy Ea is low such that the Voc value may be improved. The thermal electric conductivity energy Ea may be defined by Equation 1 below.

$$E_c - E_f = E_a \quad (Eq. 1)$$

(Ec: conduction energy level, Ef: Fermi energy level)

The Equation 1 is $E_c - E_f = E_a$ in the case of N-type, and is $E_v - E_f = E_a$ in the case of P-type. ($E_v$: valence energy level). That is, when Ea is small, the electric conductivity is good.

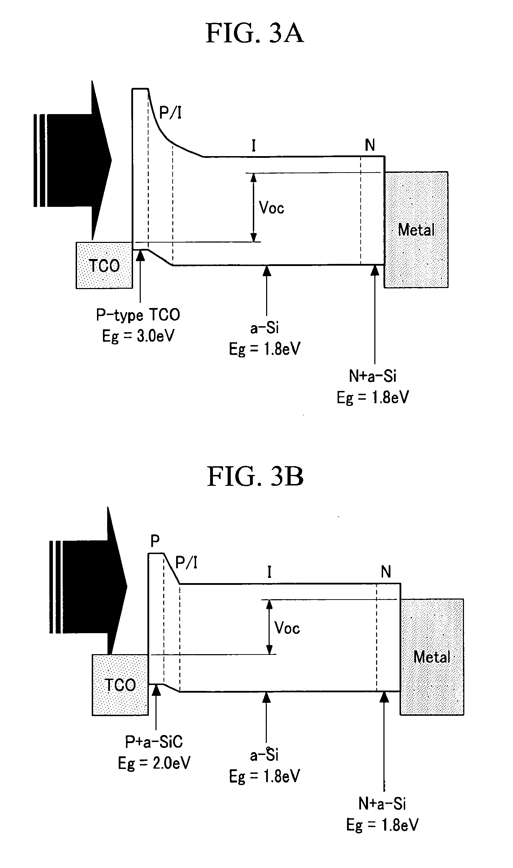

FIG. 3A is an energy band diagram of the state in which Isc is 0 upon applying a P-type oxide semiconductor according to an embodiment of the present invention, and FIG. 3B is an energy band diagram of the state in which Isc is 0 upon using amorphous silicon carbide as a P layer.

In FIG. 3A and FIG. 3B, the energy of the thermal electric conductivity of the P-type oxide semiconductor is lower than that of the thermal electric conductivity of the amorphous silicon carbide such that a $V_{oc}$ value is improved in a state of a short circuit current ($I_{sc}$=0) when using the P-type oxide semiconductor.

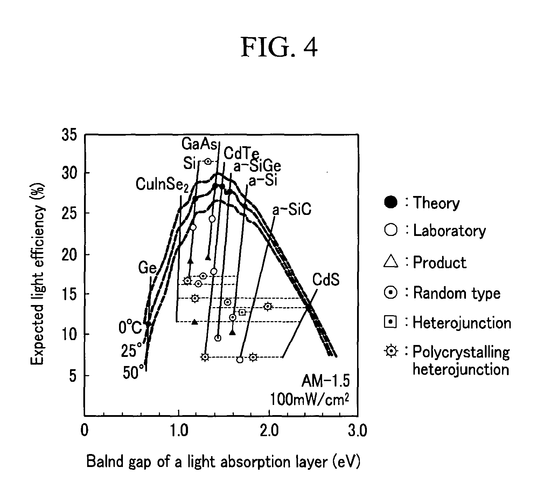

FIG. 4 is a graph showing expected light efficiency according to a band gap of a light absorption layer.

Referring to FIG. 4, it is confirmed that the energy band gap of the light absorption layer is an important factor in determining the light efficiency of the solar cell. The optimized energy band gap of the light absorption layer is about 1.5eV. As examples, amorphous silicon (a-Si), microcrystalline silicon ($\mu$c-Si), monocrystalline silicon (Si), cardmium telluride (CdTe), copper·indium·gallium·selenium (CIGS), and gallium arsenide (GaAs) may form the optimized light absorption layer of the solar cell. Accordingly, it is preferable that the P layer 130 and the I layer 140 according to an embodiment of the present invention have different band gaps. When the P layer 130 and the I layer 140 are formed of the oxide semiconductor, the band gap of the I layer of the light absorption layer is in the range of 3.0eV to 3.5eV such that the light efficiency may be decreased.

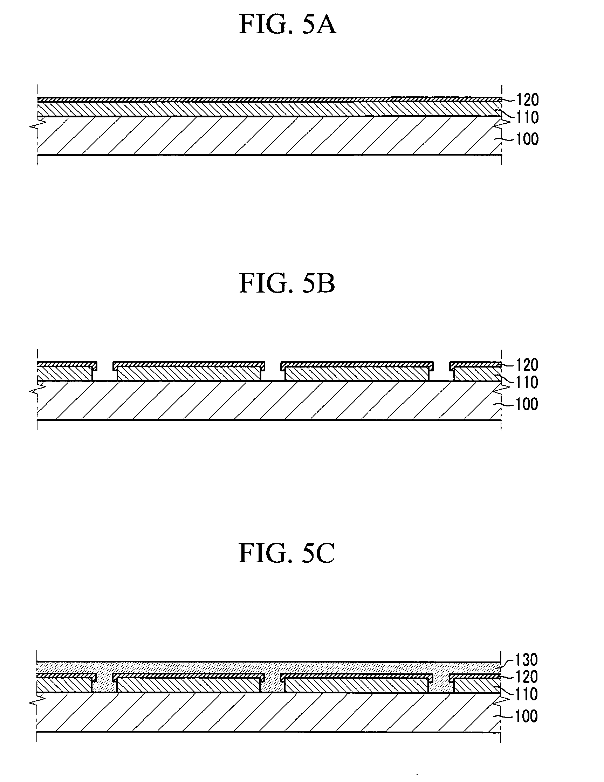

FIG. 5A to FIG. 5F are cross-sectional views sequentially showing the manufacturing process in a manufacturing method of a solar cell according to an embodiment of the present invention.

Firstly, as shown in FIG. 5A, a front transparent conductive layer 110 is deposited on a glass substrate 100, and the surface thereof is texture-treated to form a texture layer 110. Here, the thickness of the front transparent conductive layer 110 may be in the range of 7000 Å to 10,000Å in one example.

Next, as shown in FIG. 5B, the transparent conductive layer 110 is patterned by laser scribing. In one example, a laser having a wavelength of 1.06$\mu$m may be used.

Next, as shown in FIG. 5C, a P layer 130 is formed on the patterned transparent conductive layer 110. The P layer 130 may be a P-type oxide semiconductor. The thickness of the P layer 130 may be in the range of 200Å to 1000Å in one example.

Differently from the above-described method, the transparent conductive layer and the P layer may be sequentially deposited, and the transparent conductive layer and the P layer may be patterned together.

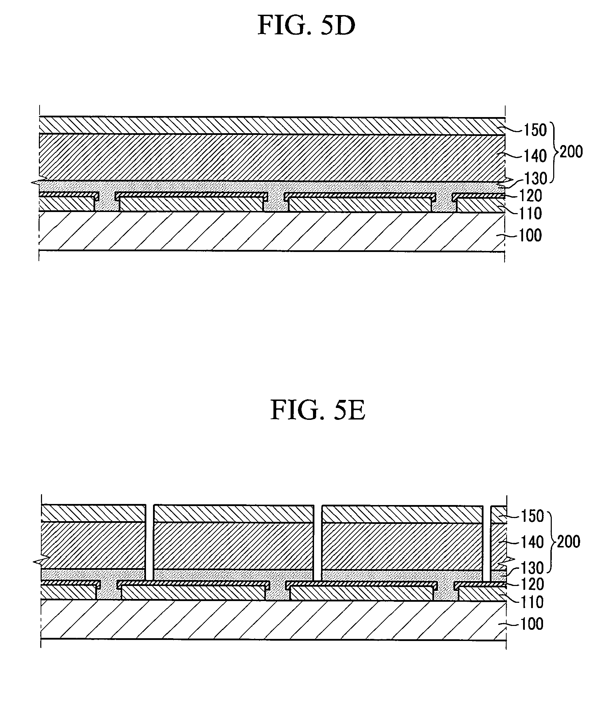

Next, as shown in FIG. 5D, an I layer 140 and a N layer 150 are sequentially deposited on the P layer 130 by plasma enhanced chemical vapor deposition (PECVD). In one example, the I layer 140 may be deposited with a thickness of 3000Å to 6000Å, and the N layer 150 may be deposited with a thickness of 200Å to 500Å.

Next, as shown in FIG. 5E, a semiconductor layer 200 including the sequentially deposited P layer 130, I layer 140, and N layer 150 is patterned by laser scribing. In one example, the laser may have a wavelength of 0.53$\mu$m.

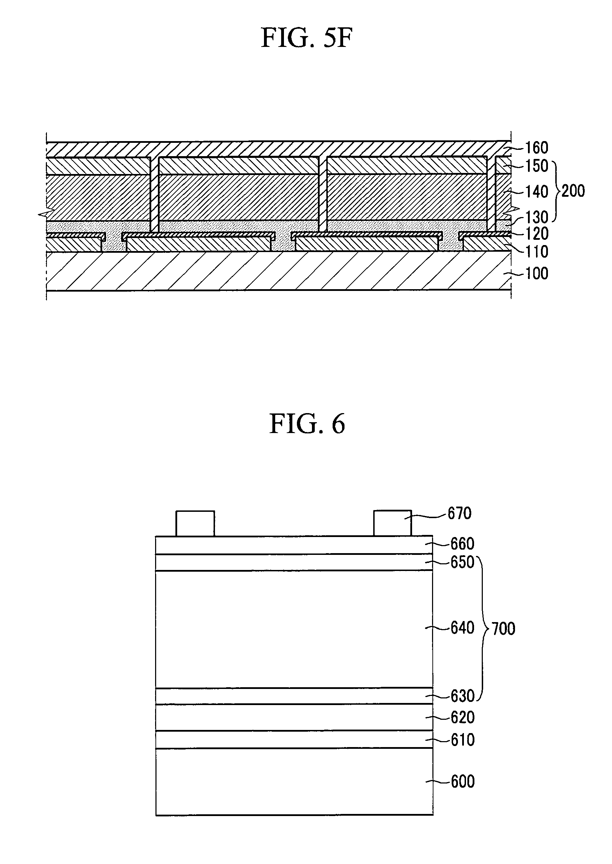

Next, as shown in FIG. 5F, a rear electrode layer 160 is deposited on the semiconductor layer 200. In one example, the rear electrode layer 160 may be formed with a thickness of 2000Å to 4000Å.

Hereafter, the rear electrode layer 160 and the semiconductor layer 200 are assumed to be patterned by laser scribing. As a result, a solar cell shown in FIG.

1 is formed.

A solar cell according to another embodiment of the present invention includes a substrate, a transparent conductive layer deposited on the substrate, a semiconductor layer having a N layer, an I layer, and a P layer sequentially deposited on the transparent conductive layer, and a rear electrode deposited on the P layer deposited on the semiconductor layer. Here, the N layer is a N-type oxide semiconductor.

The N-type oxide semiconductor may include at least one of Ga, In, Zn, Sn, Cu, Al, Sr, La, and Hf. Here, the N-type oxide semiconductor may be made of at least one of $AgInO_2$, AlO, and ZnO doped with an impurity at a low concentration.

The I layer may be made of one selected from the group of amorphous silicon (a-Si), microcrystalline silicon ($\mu$c-Si), monocrystalline silicon (Si), cardmium telluride (CdTe), copper·indium·gallium·selenium (CIGS), and gallium arsenide (GaAs).

A buffer layer that is disposed between the N layer and the I layer and functions to buffer the difference of the band gap between the N layer and the I layer may be further included.

The N layer is formed of the N-type oxide semiconductor, thereby increasing light efficiency.

The solar cell according to an embodiment of the present invention may be a substrate type of a metal/N-I-P/TCO/grid structure mainly using an opaque metal plate as well as a superstrate of a TCO/P-I-N/metal structure using a glass substrate. Hereafter, referring to FIG. 6, a solar cell applied with a substrate type according to an embodiment of the present invention will be described in detail.

Referring to FIG. 6, a solar cell of a substrate type according to an embodiment of the present invention includes a reflecting electrode 610 deposited on a substrate 600. A transparent conductive layer 620 is formed on the reflecting electrode 610. A semiconductor layer 700 of which a N layer 630, an I layer 640, and a P layer 650 are sequentially deposited is formed on the transparent conductive layer 620. A transparent conductive layer 660 is formed on the semiconductor layer 700. A connection electrode 670 that is patterned may be further formed on the transparent conductive layer 660.

The substrate 600 may be made of an opaque metal foil.

In the solar cell of the substrate type, the solar light may be incident to the I layer 640 that functions as the light absorption layer through the transparent conductive layer 660 and the P layer 650. Like the solar cell of the superstrate type, it is preferable that the P layer 650 is made of an oxide semiconductor to increase light efficiency.

While this invention has been described in connection with what is presently considered to be practical exemplary embodiments, it is to be understood that the invention is not limited to the disclosed embodiments, but, on the contrary, is intended to cover various modifications and equivalent arrangements included within the spirit and scope of the appended claims.

## Claims

1. A photovoltaic device comprising:

   a substrate;
   a transparent conductive layer deposited on the substrate;
   a semiconductor layer including a P layer, an I layer, and a N layer sequentially deposited on the transparent conductive layer, wherein the P layer is a P-type oxide semiconductor; and
   a rear electrode deposited on the N layer.

2. The photovoltaic device of claim 1, wherein the difference of the band gap between the P layer and the I layer is in the range of about 1.5eV to about 2.5eV.

3. The photovoltaic device of claim 1 further comprising a buffer layer disposed between the P layer and the I layer for buffering the difference of the band gap between the P layer and the I layer.

4. The photovoltaic device of claim 3, wherein the buffer layer is made of one selected from a group of amorphous carbon (a-C), amorphous silicon carbide (a-SiC), and amorphous silicon oxide (a-SiO).

5. The photovoltaic device of claim 3, wherein the P-type oxide semiconductor includes at least one of Ga, In, Zn, Sn, Cu, Al, Sr, La, and Hf.

6. The photovoltaic device of claim 5, wherein the P-type oxide semiconductor is made of at least one of $CuAlO_2$, $CuGaO_2$, $SrCu_2O_2$, and (LaO)CuS.

7. The photovoltaic device of claim 1, wherein the band gap of the P-type oxide semiconductor is in the range of about 3.0eV to about 3.5eV.

8. The photovoltaic device of claim 1, wherein the thickness of the P-type oxide semiconductor is in the range of about 200Å to about 1000Å.

9. The photovoltaic device of claim 1, wherein the I layer is made of at least one selected from a group of amorphous silicon (a-Si), microcrystalline silicon ($\mu$c-Si), monocrystalline silicon (Si), cardmium telluride (CdTe), copper·indium·gallium·selenium (CIGS), and gallium arsenide (GaAs).

10. The photovoltaic device of claim 9, wherein the thickness of the I layer is in the range of about 3000Å to about 6000Å.

11. The photovoltaic device of claim 9, wherein the thickness of the transparent conductive layer is in the range of about 7000Å to about 10,000Å.

12. The photovoltaic device of claim 1, wherein the band gap of the I layer is in the range of about 1.0eV to about 2.0eV.

13. The photovoltaic device of claim 1, wherein the semiconductor layer is made of a multi-layered structure in which the P layer, the I layer, and the N layer are sequentially deposited a plurality of times.

14. The photovoltaic device of claim 1, wherein the P layer and the I layer have different band gaps.

15. A photovoltaic device comprising:

    a substrate;
    a transparent conductive layer deposited on the substrate;
    a semiconductor layer provided with a N layer, an I layer, and a P layer sequentially deposited on the transparent conductive layer, wherein the N layer is a N-type oxide semiconductor; and
    a rear electrode deposited on the P layer of the semiconductor layer.

16. The photovoltaic device of claim 15, wherein:

    the difference of the band gap between the N layer and the I layer is in the range of about 1.5eV to about 2.5eV.

17. The photovoltaic device of claim 16, wherein:

    the N-type oxide semiconductor includes at least one of Ga, In, Zn, Sn, Cu, Al, Sr, La, and Hf.

18. The photovoltaic device of claim 17, wherein the N-type oxide semiconductor is made of at least one of $AgInO_2$, AlO, and ZnO doped with an impurity at a low concentration.

19. The photovoltaic device of claim 15 further comprising a buffer layer disposed between the N layer and the I layer for buffering the difference of the band gap between the N layer and the I layer.

20. The photovoltaic device of claim 15, wherein the I layer is made of at least one selected from a group of amorphous silicon (a-Si), microcrystalline silicon ($\mu$c-Si), mono crystalline silicon (Si), a cardmium telluride (CdTe), copper·indium·gallium·selenium (CIGS), and gallium arsenide (GaAs).

21. The photovoltaic device of claim 20, further comprising
a reflecting electrode disposed between the substrate and the transparent conductive layer.

22. The photovoltaic device of claim 20, further comprising
a connection electrode formed on the rear electrode.

23. A method for manufacturing a photovoltaic device comprising:

    depositing a transparent conductive layer on a substrate;
    patterning the transparent conductive layer;
    forming a semiconductor layer including a P layer, an I layer, and a N layer sequentially deposited on the patterned transparent conductive layer, wherein the P layer is made of a P-type oxide semiconductor;
    patterning the semiconductor layer;
    forming a rear electrode layer on the patterned semiconductor layer; and
    patterning the rear electrode layer and the semiconductor layer.

24. The method of claim 23, further comprising
texture-treating the surface of the transparent conductive layer to form a texture layer after depositing the transparent conductive layer.

25. The method of claim 23, wherein
the transparent conductive layer, the semiconductor layer, and the rear electrode layer are patterned by laser scribing.

26. A method for manufacturing a photovoltaic device, comprising:

    depositing a transparent conductive layer on a substrate;
    forming a P layer on the transparent conductive layer, wherein the P layer is made of a P-type oxide semiconductor;
    patterning the transparent conductive layer and the P layer;
    sequentially depositing an I layer and a N layer on the P layer;
    patterning a semiconductor layer including the P layer, the I layer, and the N layer;
    forming a rear electrode layer on the patterned semiconductor layer; and
    patterning the rear electrode layer and the semiconductor layer.

27. The method of claim 26, further comprising
texture-treating the surface of the transparent conductive layer to form a texture layer after depositing the transparent conductive layer.

28. The method of claim 26, wherein
the transparent conductive layer, the semiconductor layer, and the rear electrode layer are patterned by laser scribing.

# FIG. 1

# FIG. 2A

# FIG. 2B

# FIG. 2C

# FIG. 3A

P/I

I

N

Voc

TCO

Metal

P-type TCO
Eg = 3.0eV

a-Si
Eg = 1.8eV

N+a-Si
Eg = 1.8eV

# FIG. 3B

P

P/I

I

N

Voc

TCO

Metal

P+a-SiC
Eg = 2.0eV

a-Si
Eg = 1.8eV

N+a-Si
Eg = 1.8eV

# FIG. 4

# FIG. 5A

120
110
100

# FIG. 5B

120
110
100

# FIG. 5C

130
120
110
100

# FIG. 5D

150
140 } 200
130
120
110
100

# FIG. 5E

150
140 } 200
130
120
110
100

## FIG. 5F

160
150
140 }200
130
120
110
100

## FIG. 6

670
660
650
640 }700
630
620
610
600

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020080057797